(19) Europäisches Patentamt
European Patent Office
Office européen des brevets

(11) Publication number: **0 112 599**
**B1**

(12) **EUROPEAN PATENT SPECIFICATION**

(45) Date of publication of patent specification: **18.07.90**

(51) Int. Cl.$^5$: **H 03 L 7/08,** H 03 K 5/26

(21) Application number: **83201818.8**

(22) Date of filing: **20.12.83**

(54) **Pulse corrector.**

(30) Priority: **22.12.82 BE 2059975**

(43) Date of publication of application:
**04.07.84 Bulletin 84/27**

(45) Publication of the grant of the patent:
**18.07.90 Bulletin 90/29**

(84) Designated Contracting States:
**DE FR GB IT NL**

(56) References cited:
**BE-A- 893 180**
**BE-A- 895 439**
**US-A-4 017 803**
**US-A-4 363 003**

(73) Proprietor: **BELL TELEPHONE MANUFACTURING COMPANY Naamloze Vennootschap**
**Francis Wellesplein 1**
**B-2018 Antwerp (BE)**
(84) **NL**

(73) Proprietor: **ALCATEL N.V.**
**Strawinskylaan 537 (World Trade Center)**
**NL-1077 XX Amsterdam (NL)**
(84) **DE FR GB IT**

(72) Inventor: **Hoefman, Marc Edmond Maria**
**Vlasstraat 25**
**B-2700 St.-Niklaas (BE)**

(74) Representative: **Vermeersch, Robert et al**
**BELL TELEPHONE MANUFACTURING COMPANY Naamloze Vennootschap Patent Department Francis Wellesplein 1**
**B-2018 Antwerp (BE)**

**EP 0 112 599 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a pulse corrector which in response to first and second input pulses applied its first and second inputs provides first and second output pulses at its first and second outputs respectively, the first pulse edge occurring at said first output after an interruption of said first pulses never leading the corresponding first pulse edge occurring at said second output irrespective of the phase relationship between the corresponding first pulse edges occurring at said inputs after said interruption.

Such a pulse corrector is already known from the Belgian patent BE—A—893 180 (R. BRAUN) and is for instance useful for a phaselocked loop incorporating a digital phase detector with its two inputs respectively connected to the first and second, or reference and comparison outputs, of the pulse corrector and with the first and second, or reference or comparison, inputs of the latter respectively connected to the output of a source of reference pulses and to the output of the voltage controlled oscillator providing comparison pulses at this output. As described in the above patent, after the end of an interruption of this source and irrespective of the phase relationship, at that moment, between the comparison pulses and the reference pulses, the pulse corrector produces at its reference output a first pulse edge which never leads the corresponding first pulse edge produced at the comparison output of this corrector. The purpose of these first pulse edges is to bring the phase detector finally in a predetermined neutral state wherein both its outputs are activated before allowing again reference pulses to its input. To be able to influence the detector, the duration of the pulse at the reference output starting with the above mentioned first edge has to be sufficiently long.

It has been found that under certain circumstances this duration can be insufficient, as will be appreciated from the following. According to the previously mentioned Belgian patent the above mentioned first pulse edge at the reference output of the corrector is produced a certain time interval after the occurrence of the first pulse edge at the reference input after the end of an interruption and also after the occurrence of the corresponding first pulse edge at the comparison input. The length of this time interval depends on the phase difference between these first pulse edges and on delays in the pulse corrector. The second pulse edge at the reference output immediately following the above mentioned first pulse edge at the same output is generated substantially immediately after the ocurrence of the second pulse edge at the reference input following the above mentioned first pulse edge at the same input. Hence, the duration of the first pulse, delimited by the above first and second edges, produced at the reference output after the end of an above mentioned interruption, is dependent on the above mentioned phase difference and delays and on the duration of the corresponding first pulse at the reference input. The latter duration is itself dependent on the frequency of the reference pulses and on this first pulse being mutilated or not. Since, as mentioned above, the duration of the first pulse at the reference output of the corrector should be sufficiently long to bring the phase detector in a predetermined state, in a practical embodiment of the phase lock loop the frequency of the reference pulses had to be limited to 4 MHz.

The pulse corrector according to the above patent further includes a monostable circuit which detects the presence or absence of pulses at the reference input and starts a pulse correcting operation when these reference pulses are absent at the input for a predetermined counted time interval. However, after such an interruption, the comparison pulses continue appearing at the comparison output as long as this time interval has not elapsed and the edges of these pulses normally bring the phase detector in a number of successive intermediate states before it is finally brought in the above mentioned neutral position by the above mentioned first edge of the first reference pulse. However, if this time interval is too small, e.g. because the monostable circuit operates with too large a tolerance, and/or if the interruption of the reference pulses at the input is shorter than this time interval, it can happen that due to an insufficient number of comparison pulse edges being applied to the detector the latter is finally not brought in its above mentioned neutral state.

An object of the present invention is to provide a pulse corrector of the above type but wherein the duration of the pulse at the first output starting with the first edge is substantially independent of delays in the corrector and of the phase shift between the pulses at the inputs at the end of an interruption of the first input pulses and which moreover does not present the last mentioned drawback.

According to this invention this object is achieved due to the fact that it includes:

a detection circuit [RMS] having an input constituted by said first pulse corrector input [T] and being able to detect the re-appearance of first input pulses [T] at the end of said interruption and to then activate its detection output [MS], said second output pulses [V] being only dependent on and synchronous with said second input pulses [S] which are not interrupted when said first input pulses [T] are interrupted;

a counting circuit [SR] having inputs coupled to said detection outputs [MS] and to said second input [S] an being able to count a predetermined number of edges of said second input pulses [S] after said detection output [MS] has been activated and to then activate its counter output [QD] in coincidence with the first edge [S4↑] of one second input pulse [S4];

a first memory circuit [JKFF] to register the activated condition of said counter output [QD] under the control of a second edge [S4↓] of said one second input pulse [S4], said first memory

circuit then activating its memory output [Q1]; and

a first gating circuit [G1, OR, INV1] having inputs coupled to said counter [QD] and memory [Q1] outputs and having a gating output coupled [OR, INV1] to said first pulse output [R], said gating circuit producing at said first pulse output [R] an output signal $\overline{QD, \overline{Q1}}$ which constitutes a predetermined first output pulse [TL] whose edges are slightly delayed with respect to those of said one second input pulse [S4] and wherein QD and Q1 are the conditions of said counter and memory outputs respectively.

Thus the duration of the predetermined first output pulse is equal to the duration of a second input pulse. As the last mentioned duration is constant, the first mentioned one is independent of delays in the pulse corrector and of the phase shift, after an interruption, between the first and second input pulses. Moreover this pulse duration is also independent of mutilated pulses because the synchronous second input and output pulses are not interrupted when the first input pulses are interrupted. Because, as mentioned above, the second input pulses are not interrupted and the second output pulses are synchronous therewith, the counting means can always count, from the end of an interruption, a wanted number of edges of the second input pulses which then appear at the second output of the corrector as a like number of edges of second output pulses before the above mentioned first edge is produced at this first output. By using the present pulse corrector in the phaselocked loop according to the above mentioned Belgian patent, it has been possible to ensure a correct operation and to increase the frequency of the reference pulses at the first input from 4 Hz to 8 Hz.

The above mentioned and other objects and features of the invention will become more apparent and the invention itself will be best understood by referring to the following description of an embodiment taken in conjunction with the accompanying drawings in which:

Fig. 1 is a block diagram of a phaselock loop including a pulse corrector PC according to the invention;

Fig. 2 shows this pulse corrector PC in more detail;

Fig. 3 represents various pulse signals appearing at various points of the pulse corrector PC of Fig. 2 and of the digital phase detector DPD of Fig. 1;

Fig. 4 represents all the possible states of the digital phase detector DPD of Fig. 1.

The phaselock loop PLL shown in Fig. 1 comprises the cascade connection of a pulse corrector PC, a digital phase detector DPD, a filter network FN and a voltage controlled oscillator VCO. The pulse corrector PC has a reference input T connected to a source of reference pulses T (Fig. 3), a comparison input S connected to the output of the VCO producing comparison pulses S (Fig. 3) thereat, a refenence output R and a comparison output V. The outputs R and V are connected to like-named inputs of the DPD which is of a type generally available on the market, e.g. MC4044 of Motorola. Phase detector DPD has outputs PU and PD which are connected to like named inputs of the filter network FN and are associated with the inputs R and V respectively.

The twelve possible states of the phase detector are represented in Fig. 4 with in each circle (L for Low and H for High) the conditions R, V, PU and PD as indicated in the left hand upper corner of this figure. Each circle numbered from 1 to 12 indicating a particular state is connected to at least one other circle by a line terminating in an arrow indicating the state to which the particular state evolves when the signal at the input R or V varies from H to L (indicated by R↓ or V↓) or from L to H (indicated by R↑ or V↑). If an input R, V changes from H to L, the condition of the associated output PU, PD changes from H to L, if it was previously in H and does not change when it was previously in L. If an output PU, PD is in L and the condition of the non-associated input V, R changes from H to L, the condition of the output PU, PD changes from L to H. In other words, when input R changes from H to L, PU can change from H to L and PD can change from L to H, whereas when input V changes from H to L, PD can change from H to L and PU can change from L to H. PU and PD can never simultaneously be in L.

The states 5 to 8 are neutral states wherein both the outputs PU and PD are high, whilst the states 1 to 4 and 9 to 12 are active states wherein PU and PD are low respectively.

In the phaselock loop PLL the frequency and phase of the comparison pulses S of the VCO are adjusted to both the frequency and the phase of the reference pulses T. A pulse appears at the output PU whenever the phase of a pulse at input R leads the phase of a pulse at input V, and a signal appears at output PD whenever the phase of the signal at input R lags behind the phase of the signal at input V. The pulses at output PU or PD have a width proportional to this phase difference.

When the reference pulses T are interrupted, e.g. due to a failure of the reference source or because another reference source is being connected to reference input T, the phase of the reference pulses T appearing at input T after the interruption may be leading or lagging with respect to the phase of the reference pulses which were present at input T before the interruption. As explained at length in the above mentioned Belgian patent 893 180 (R. BRAUN 6), without a pulse corrector PC the phase adjustment realized by the phaselock loop is carried out in the wrong direction when the phase of the reference pulses T appearing at input T after the interruption leads the phase of the reference pulses signal which were present at input T prior to the interruption. However, by the use of the pulse corrector PC this faulty operation is obviated since it operates in such a way that the conditions of its outputs R, V are function of the conditions of its input T, S and that the first edge of the reference pulses occurring at the reference output R after an interruption of the reference pulses T at the reference input T always lags behind the corresponding first edge of the comparison pulses at the comparison output V irrespective of the phase relationship between the corresponding edges at the reference and comparison inputs T and S of the pulse corrector PC at that moment.

The pulse corrector shown in Fig. 2 has a reference input T, a comparison input S, a reference output R and a comparison output V and includes a retriggerable monostable circuit RMS, a shift register SR, a negative edge triggered JK flipflop JKFF, a positive edge triggered D-flipflop DFF, AND-gates G1 and G2, OR-gate OR and inverters INV1 and INV2. All these circuits are interconnected as shown and are generally available on the market.

First, the various conditions shown in the left hand part of Fig. 3 will be explained. The monostable circuit RMS is connected to the reference input T and constitutes a detecting means for detecting the absence or presence reference pulses at this input T. Indeed, as long as such reference pulses T are present the monostable circuit RMS is triggered by each of the positive going edges of these reference pulses T so that its output MS which controls the so-called serial data input A of the shift register SR continuously remains in the H-State. By the positive going edges of the comparison pulses S the condition H is shifted through the shift register SR so that at a certain moment the output QD thereof and hence the J-input of the JKFF is brought in the H-state. By the negative going edge of S (not shown) following the positive going edge of S (also not shown) by which this J-input of the JKFF was brought in the H-condition the outputs $Q_1$ and $\overline{Q}_1$ of the JKFF are triggered to the H- and L-condition respectively. As the AND-gate G1 is controlled by the outputs QD and $\overline{Q}_1$ the output signal $QD.\overline{Q}_1$ of G1 is then in the L-state. The signal in the H-condition at the output $Q_1$ of the JKFF is registered in the D-flipflop DFF by the positive going edge (not shown) of the reference pulses T following the last mentioned negative going edge of S. As a consequence the output Q2 of the DFF is brought in the H-condition. Because the AND-gate G2 is controlled by the outputs Q2 and T the output signal Q2.T of G2 then follows the reference pulses T. The pulses at the outputs of G1 and G2 are applied to OR-gate OR and from there via inverter INV1 to reference output R on which appears a reference pulse signal.

$$R = QD.\overline{Q}_1 + Q_2.T \text{ or } QD.\overline{Q}_1.Q_2.T$$

Herein $QD.\overline{Q}_1$ and $Q_2.T$ are the inverse of the output signals of G1 and G2 and are shown on Fig. 3. Because $QD.\overline{Q}_1$ is L and $Q_2$ is H, $R = \overline{T}$ so that the inverse of the reference pulses T appears at the output R of PC. At the output V of the PC always appears the signal $V = \overline{S}$ i.e. the inverse of the comparison pulses S. To be noted that due to the presence of the gates G1 and G2 and the inverter INV1 the edges of R are slightly delayed with respect to those of T. The pulses at the outputs R, V of PC and at the outputs PU and PD of the DPD evolve as shown in the left hand part of Fig. 3, the corresponding states of DPD being shown on the last line ST. These states may readily be found by considering Fig. 4.

As an example it is now supposed that the reference pulses T at the reference input T are interrupted upon the occurrence of a positive going edge of T. When this interruption lasts for a time interval larger than the time constant TS the monostable circuit RMS is reset to its zero condition wherein its output MS is in L. The shift register SR and both the fliplops JKFF and DFF are then reset and the serial data input A of this shift register is brought in the L-condition. As a consequence the outputs QD, $Q_1$ and $Q_2$ are brought in the L-condition, so that the reference output R is brought in the H-condition (see the above relation). The conditions of the outputs R, V of PC and PU, PD of DPD are again shown in Fig. 3, the successive states of the DPD being again represented on the last line ST of this figure.

After the interruption of the reference pulses T is finished these pulses T have the phase shift shown with respect to the pulses R. The first positive going edge of T, i.e. the positive going edge of pulse T1, triggers the monostable circuit RMS to its unstable condition wherein its output MS is in the H-condition. Due to this, the latter H-condition is shifted through the register SR by the positive going edges of the comparison pulses S following the above mentioned first positive going edge of T, i.e. by the positive going edges of T, i.e. by the positive going edges of the pulses S1, . . . , S4, S5, . . . etc. Thus the condition of the outputs QA, . . . Qd, . . . of the shift register changes to H at the positive going edges of the pulses S1, . . . S4, . . . respectively. When the condition of the output QD of SR becomes H at the positive going edge of S4, the inverse condition $QD.\overline{Q}_1$ of the output signal $QD.\overline{Q}_1$ of the gate G1 becomes L slightly after the positive going edge of S4 due to the delay in the gate G1. Afterwards, the H-condition of the output QD is registered in the JKFF by the immediately following negative going edge of S4. Thus the condition of the outputs $Q_1$ and $\overline{Q}_1$ of the JKFF become H and L respectively so that the inverse $QD.\overline{Q}_1$ of the condition of the output signal of AND-gate G1 again becomes H slightly after the negative going edge of S4. The H-condition of the output $Q_1$ of the JKFF is registered in the D-flipflop DFF by the positive going edge of the reference signal T immediately following the last mentioned negative going edge of S4, i.e. by the positive going edge of T5. Thus the condition of the output Q2 of the DFF becomes H so that the inverse $\overline{Q_2.T}$ of the condition of the output signal of AND-gate G2 follows the inverse of signal T. Because the output pulses at the reference output R are equal to $QD.\overline{Q}_1.Q_2T$ this signal evolves as shown in Fig. 3 and the states of the DPD evolve as shown in Fig. 3 and the states of the DPD evolve as shown

in the last line ST of this figure and as follows from Fig. 4.

From figure 3 it also follows that before the inverse of the pulses T is allowed to appear on the reference output R the condition of the latter output R is made L for a time interval TL substantially equal to the duration of the pulse S4, both the edges of this time interval being slightly delayed with respect to those of S4 due to the presence of the gates G1 and G2. In other words and because $V = \overline{S}$, the first negative going edge of R (or R↓) after an interruption always lays behind the corresponding negative going edge of V (or V↓) by a small delay so that the outputs PU and PD of the digital phase detector DPD vary as shown in Fig. 3. Due to the duration of the negatively directed pulse TL at the output R being substantially equal to S4 one is moreover sure that the DPD will operate correctly if S4 is sufficiently long, e.g. larger than 30 milliseconds which is the minimum reaction time of the DPD used.

The purpose of the shift register SR is to ensure that after the end of an interruption a predetermined number V↑ and V↓ is applied to the phase detector before R↓ is applied to it at the start of the time interval TL, all these V↑ and V↓ making that the detector evolves through a number of intermediate states and R↓ bringing it finally in the neutral state 5. This will become clear from the following.

For the case shown in Fig. 3 one has a succession of R↑ R↓ V↑ and V↓ which is such that the DPD evolves:

from the active state 2 successively to the neutral state 5, 8 and 7;

from the start of the interruption to the end thereof, to the active state 2 and from this successively to the neutral states 5 and 6 and the active states 9, 10, 11 and 12;

from the end of the interruption alternatively from state 12 to 11 by a predetermined number of V↑ and V↓ counted by the shift register SR to be finally brought in the neutral state 5 by R↓ at the start of TL. Irrespective the state of the face detector at the end of the interruption, this predetermined number of V↑ and V↓ is sufficient to bring this detector in the state 12 before applying R↓ thereat. This operation is also independent from the value of TS and the duration of the interruption;

afterwards again through the states 8, 7, 2 (except for the first time where it passes through state 6 instead of through state 8).

It should however be noted that the shift register SR sychronizes the reference pulses R, again appearing at the output R after the end of an interruption, with the comparison pulses V which were not interrupted. Instead of such a shift register SR also a counter for the pulses S could have been used.

**Claims**

1. Pulse corrector which in response to first [T] and second [S] input pulses applied to its first [T] and second [S] inputs provides first [R] and second [V] output pulses at its first [R] and second [V] outputs respectively, the first pulse edge occurring at said first output [R] after an interruption of said first pulses never leading the corresponding first pulse edge occurring at said second output irrespective of the phase relationship between the corresponding first pulse edges occurring at said inputs after said interruption, characterized in that it includes:

a detection circuit [RMS] having an input constituted by said first pulse corrector input [T] and being able to detect the re-appearance of first input pulses [T] at the end of said interruption and to then activate its detection output [MS], said second output pulses [V] being only dependent on and synchronous with said second input pulses [S] which are not interrupted when said first input pulses [T] are interrupted;

a counting circuit [SR] having inputs coupled to said detection outputs [MS] and to said second input [S] and being able to count a predetermined number of edges of said second input pulses [S] after said detection output [MS] has been activated and to then activate its counter output [QD] in coincidence with the first edge [S4↑] of one second input pulse [S4];

a first memory circuit [JKFF] to register the activated condition of said counter output [QD] under the control of a second edge [S4↓] of said one second input pulse [S4], said first memory circuit then activating its memory output [Q1]; and

a first gating circuit [G1, OR, INV1] having inputs coupled to said counter [QD] and memory [Q1] outputs and having a gating output coupled [OR, INV1] to said first pulse output [R], said gating circuit producing at said first pulse output [R] an output signal QD, $\overline{Q1}$ which constitutes a predetermined first output pulse [TL] whose edges are slightly delayed with respect to those of said one second input pulse [S4] and wherein QD and Q1 are the conditions of said counter and memory outputs respectively.

2. Pulse corrector according to claim 1, characterized in that it further includes:

a second memory circuit [DFF] coupled to said memory output [Q1] and able to store the registered condition of said first memory circuit [JKFF] under the control of an edge [T5] of said first input pulses [T] following said first pulse edge [S4↓] of said one second input pulse [S4];

and a second gating circuit [G2, OR, INV1] coupled to said first input [T] and to an output [Q2] of said second memory circuit [DFF] and having an output coupled [OR, INV1] to said first pulse corrector output [R], said second gating circuit [GQ2] producing an output signal $\overline{Q2.T}$ which is added to said predetermined first output pulse [TL] and wherein

Q2 is the condition of said output of said second memory circuit [DFF] and

T is the condition of said first pulse input.

3. Pulse corrector according to claim 2, characterized in that said detection circuit is constituted by a retriggerable monostable circuit [RMS] having an input constituted by said first pulse input [T] and having said detection output [MS] coupled to data [D] and reset [R] inputs of a shift register [SR] which constitutes said counting circuit and further has a clock input [S] coupled to said second pulse input [S] and said counter output [QD] which is coupled to said first memory circuit [JKFF] and to said first gating circuit [G1], the operation of said first memory circuit [JKFF] being started when said monostable circuit [RMS] has detected the reappearance of first input pulses [T] at the end of said interruption and when said shift register [SR] has counted said predetermined number of edges of said second input pulses [S] and has accordingly activated its said counter output [QD].

4. Pulse corrector according to claim 3, characterized in that said first memory circuit is a JK flipflop [JKFF] having a J-input coupled to said shift register output [QD] and a clock input [C] coupled to said second pulse input [S].

5. Pulse corrector according to claim 4, characterized in that said second memory circuit is a D-flipflop having a D-input connected to the output of said JK-flipflop and a clock input [C] coupled to said first pulse input [T].

6. Pulse corrector according to claim 1, characterized in that said second pulse input [S] is connected to said second pulse corrector output [V] via an inverter [INV2].

**Patentansprüche**

1. Impulskorrigierer, der als Antwort auf erste [T] und zweite [S] Eingangsimpulse, die an seinen ersten [T] und zweiten [S] Eingang angelegt sind, erste [R] bzw. zweite [V] Ausgangsimpulse an seinem ersten [R] bzw. zweiten [V] Ausgang abgibt, wobei die erste Impulsflanke, die nach einer Unterbrechung der ersten Impulse am ersten Ausgang [R] auftritt, nie vor der entsprechenden ersten Impulsflanke erscheint, die am zweiten Ausgang auftritt, unabhängig von der Phasenbeziehung zwischen den ersten Impulsflanken, die nach der Unterbrechung zwischen den Eingängen auftreten, dadurch gekennzeichnet, daß er enthält:

eine Detektor [RMS], mit einem Eingang, der vom ersten Eingang [T] des Impulskorrigierers gebildet wird und der geeignet ist, den Wiederbeginn der ersten Eingangsimpulse [T] nach Beendigung der Unterbrechung festzustellen und dann seinen Detektorausgang [MS] zu aktivieren, wobei die zweiten Ausgangsimpulse [V] nur abhängig sind von und zynchron mit den zweiten Eingangsimpulsen [S], die nicht unterbrochen werden, wenn die ersten Eingangsimpulse [T] unterbrochen werden;

einen Zähler [SR] mit Eingängen, die mit dem Detektorausgang [MS] und dem zweiten Eingang [S] verbunden sind und in der Lage ist, eine vorbestimmte Anzahl von Flanken des zweiten Eingangsimpulses [S] abzuzählen, nachdem der Detektorausgang [MS] aktiviert wurde und dann seinen Zählerausgang [QD] gleichzeitig mit der ersten Flanke [S4 ↑] eines zweiten Eingangsimpulses [S4] zu aktivieren;

einen ersten Speicher [IKFF] zum Übernehmen der aktivierten Bedingung des Zählerausgangs [QD] beim beim Aufhalten einer zweiten Flanke [S4] des einen zweiten Eingangsimpulses [S4], wonach d er erste Speicher seinen Speicherausgang [Q1] aktiviert; und

erste Gatter [G1, OR, INV1] mit Eingängen, die an die Zähler- [QD] und Speicher- [Q1] Ausgänge angeschlossen sind und einem Ausgang, der mit dem ersten Ausgang [R] verbunden [OR, INV1] ist, wobei die ersten Gatter am ersten Ausgang [R] ein Ausgangssignal QD Q1 erzeugen, das einen vorherbestimmten ersten Ausgangsimpuls [TL] erzeugt, dessen Flanken gegenüber denen des einen zweiten Eingangsimpulses leicht verzögert sind, wobei QD und Q1 die Bedingungen des Zähler- bzw. Speicherausgangs sind.

2. Impulskorrigierer 1, dadurch gekennzeichnet, daß er weiter enthält:

einen zweiten Speicher [DFF], der mit dem Speicherausgang [Q1] verbunden ist und geeignet ist, die übernommene Bedingung des ersten Speichers [IKFF] beim Auftreten einer auf die erste Impulsflanke [S4] de seiner zweiten Eingangsimpulses [S4] folgenden Flanke [T5] des ersten Eingangsimpulses [T5] zu überneh men;

und zweite Gatter [G2, OR, INV1], die mit dem ersten Eingang [T] und einem Ausgang [Q2] des zweiten Speichers [DFF] verbunden sind und einen Ausgang aufweisen, der mit dem ersten Ausgang [R] des Impulskorrigierers verbunden [OR, INV1] ist, wobei die zweiten Gatter [GQ2] ein Ausgangssignal Q2 T erzeugen, das zum vorherbestimmten ersten Ausgangsimpuls [TL] addiert wird, wobei Q2 die Bedingung am Ausgang des zweiten Speichers [DFF] und T die Bedingung am ersten Eingang ist.

3. Impulskorrigierer, dadurch gekennzeichnet, daß der Detektor durch ein nachtriggerbares Monoflop [RMS] gebildet wird, das einen Eingang aufweist, der vom ersten Eingang [T] des Impulskorrigierers gebildet wird und dessen Detektorausgang [M5] mit Daten- [D] und Reset- [R] Eingängen eines Schieberegisters [SR] verbunden ist, das den Zähler bildet und das weiter einen Takteingang [S] aufweist, der mit dem zweiten Eingang [S] des Impulskorrigierers verbunden ist, wobei der Zählerausgang [QD] mit dem ersten Speicher [IKFF] und den ersten Gattern [G1] verbunden ist, wobei der erste Speicher [IKFF] dann zu arbeiten beginnt, wenn das Monoflop [RMS] den Wiederbeginn der ersten Eingangsimpulse [T] nach Beendigung der Unterbrechung festgestellt hat und wenn das Schieberegister [SR] die vorgegebene Anzahl von Flanken des zweiten Eingangsimpulses [S] abgezählt und infolgedessen seinen Zählerausgang [QD] aktiviert hat.

4. Impulskorrigierer nach Anspruch 3, dadurch gekennzeichnet, daß der erste Speicher ein JK-Flipflop [JKFF] ist, mit einem J-Eingang, der mit dem Schieberegisterausgang [QD] verbunden ist

und mit einem Takteingang [C], der mit dem zweiten Eingang [S] des Impulskorrigierers verbunden ist.

5. Impulskorrigierer nach Anspruch 4, dadurch gekennzeichnet, daß der zweite Speicher ein D-Flipflop ist das einen D-Eingang aufweiset, der mit dem Ausgang des IK-Flipflops verbunden ist und das einen Takteingang [C] aufweist, der mit dem ersten Eingang [T] des Impulskorrigierers verbunden ist.

6. Impulskorrigierer nach Anspruch 1, dadurch gekennzeichnet, daß der zweite Eingang [S] des Impulskorrigierers mit dem zweiten Ausgang [V] des Impulskorrigierers über einen Inverter [INV2] verbunden ist.

**Revendications**

1. Correcteur d'impulsions qui, en réponse à des premières [T] et secondes [S] impulsions d'entrée appliquées à ses premières [T] et seconde [S] entrées, produit des premières [R] et des secondes [V] impulsions de sortie respectivement à ses première [R] et seconde [V] sorties, le premier flanc d'impulsion se produisant à ladite première sortie [R] après une interruption desdites premières impulsions ne précédant jamais le premier flanc d'impulsion correspondant se produisant à ladite seconde sortie, indépendamment de la relation de phase existant entre les premiers flancs d'impulsions correspondants se produisant auxdites entrées après ladite interruption, caractérisé en ce qu'il comprend:

un circuit de détection [RMS] comportant une entrée constituée par ladite première entrée [T] du correcteur d'impulsions et capable de détecter la ré-apparition de premières impulsions d'entrée [T] à la fin de ladite interruption et d'activer ensuite sa sortie de détection [MS], lesdites secondes impulsions de sortie [V] étant seulement dépendantes de et synchronisées avec lesdites secondes impulsions d'entrée [S] qui ne sont pas interrompues lorsque lesdites premières impulsions d'entrée [T] sont interrompues;

un circuit de comptage [SR] comportant des entrées reliées avec ladite sortie de détection [MS] et avec ladite seconde entrée [S] et étant capable de compter un nombre prédéterminé de flancs desdites secondes impulsions d'entrée [S] après que ladite sortie de détection [MS] a été activée, puis d'activer ensuite sa sortie de compteur [QD] en coïncidence avec le premier flanc [S4 ↑ ] d'une seconde impulsion d'entrée [S4];

un premier circuit de mémoire [JKFF] pour enregistrer la condition d'activation de ladite sortie de compteur [QD] sous la commande d'un second flanc [S4 ↓ ] de ladite seconde impulsion d'entrée [S4], ledit premier circuit de mémoire activant alors sa sortie de mémoire [Q1];

un premier circuit de distribution [G1, OR, INV1] comportant des entrées reliées auxdites sorties de compteur [QD] et de ladite mémoire [Q1] et comportant une sortie de distribution reliée [OR, INV1] avec ladite première sortie d'impulsion [R], ledit circuit de distribution produisant à ladite première sortie d'impulsion [R] un signal de sortie $QD.\overline{Q1}$ qui constitue une première impulsion de sortie prédéterminée [TL] dont les flancs sont légèrement retardés par rapport à ceux de ladite seconde impulsion d'entrée [S4], QD et Q1 correspondant respectivement aux conditions desdites sorties du compteur et de la mémoire.

2. Correcteur d'impulsions selon la revendication 1, caractérisé en ce qu'il comprend en outre:

un second circuit de mémoire [DFF] relié à ladite sortie de mémoire [Q1] et capable de mémoriser la condition enregistrée dudit premier circuit de mémoire [JKFF] sous la commande d'un flanc [T5] desdites premières impulsions d'entrée [T] suivant ledit premier flanc [S4'] de ladite seconde impulsion d'entrée [S4];

et un seconde circuit de distribution [G2, OR, INV1] relié à ladite première entrée [T] et à une sortie [Q2] dudit second circuit de mémoire [DFF] et comportant une sortie reliée [OR, INV1] à ladite première sortie [R] du correcteur d'impulsions, ledit second circuit de distribution [GQ2] produisant un signal de sortie Q2.T qui est additionné avec ladite première impulsion de sortie prédéterminée [TL] et en ce que:

Q2 désigne la condition de ladite sortie dudit second circuit de mémoire [DFF] et

T désigne la condition de ladite première entrée d'impulsions.

3. Correcteur d'impulsions selon la revendication 2, caractérisé en ce que ledit circuit de détection est constitué par un circuit monostable réenclenchable [RMS] comportant un entrée constituée par ladite première entrée d'impulsions [T] et ayant ladite sortie de détection [MS] reliée à des entrées de données [D] et de remise à zéro [R] d'un registre à décalage [SR] qui constitue ledit circuit de comptage, et comporte en outre une entrée d'horloge [S] reliée à ladite seconde entrée d'impulsions [S] et à ladite sortie de compteur [QD] qui est reliée audit premier circuit de mémoire [JKFF] et audit premier circuit de distribution [G1], le fonctionnement dudit premier circuit de mémoire [JKFF] étant enclenché quand ledit circuit monostable [RMS] a détecté la réapparition de premières impulsions d'entrée [T] à la fin de ladite imterruption et quand ledit registre à décalage [SR] a compté ledit nombre prédéterminé de flancs desdites secondes impulsions d'entrée [S] et a assuré en correspondance l'activation de ladite sortie de compteur [QD].

4. Correcteur d'impulsions selon la revendication 3, caractérisé en ce que ledit premier circuit de mémoire est une bascule JK [JKFF] comportant une entrée-J reliée à ladite sortie [QD] du registre à décalage et une entrée d'horloge [C] reliée à ladite seconde entréee d'impulsions [S].

5. Correcteur d'impulsions selon la revendication 4, caractérisé en ce que ledit second circuit de mémoire est une bascule-D comportant une entrée-D reliée à la sortie de ladite bascule-JK et une entrée d'horloge C reliée à ladite première entrée d'impulsions [T].

6. Correcteur d'impulsions selon la revendication 1, caractérisé en ce que ladite seconde entrée d'impulsions [S] est reliée à ladite seconde sortie [V] du correcteur d'impulsions par l'intermédiaire d'un inverseur [INV2].

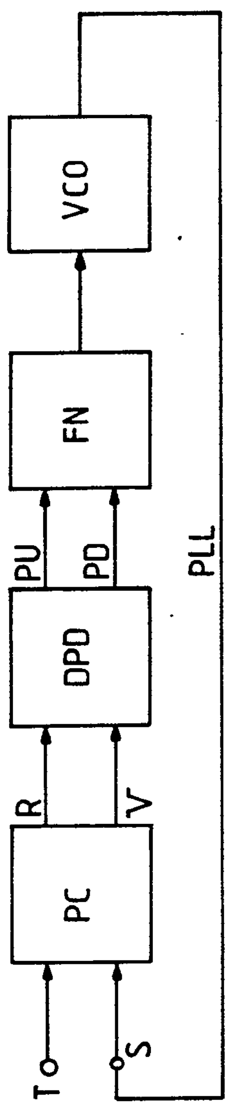
T
S
PC
R
V
DPD
PU
PD
FN
VCO
PLL

FIG.1

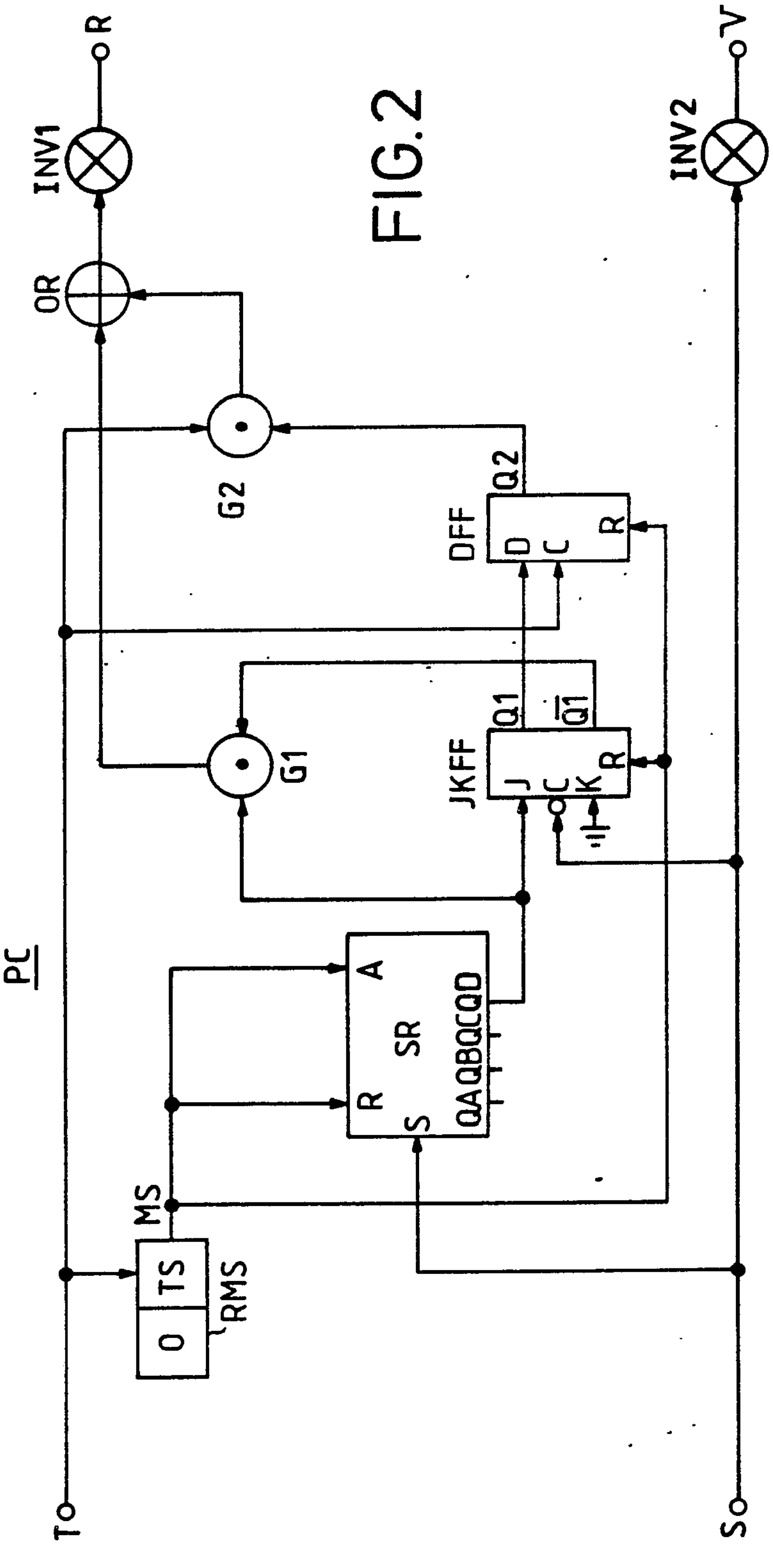
R
INV1
OR
G2
DFF
D
C
R
Q2
G1
JKFF
J
C
K
R
Q1
Q̄1
SR
A
R
S
QAQBQCQD
MS
TS
O
RMS
PC
T
S
V
INV2

FIG.2

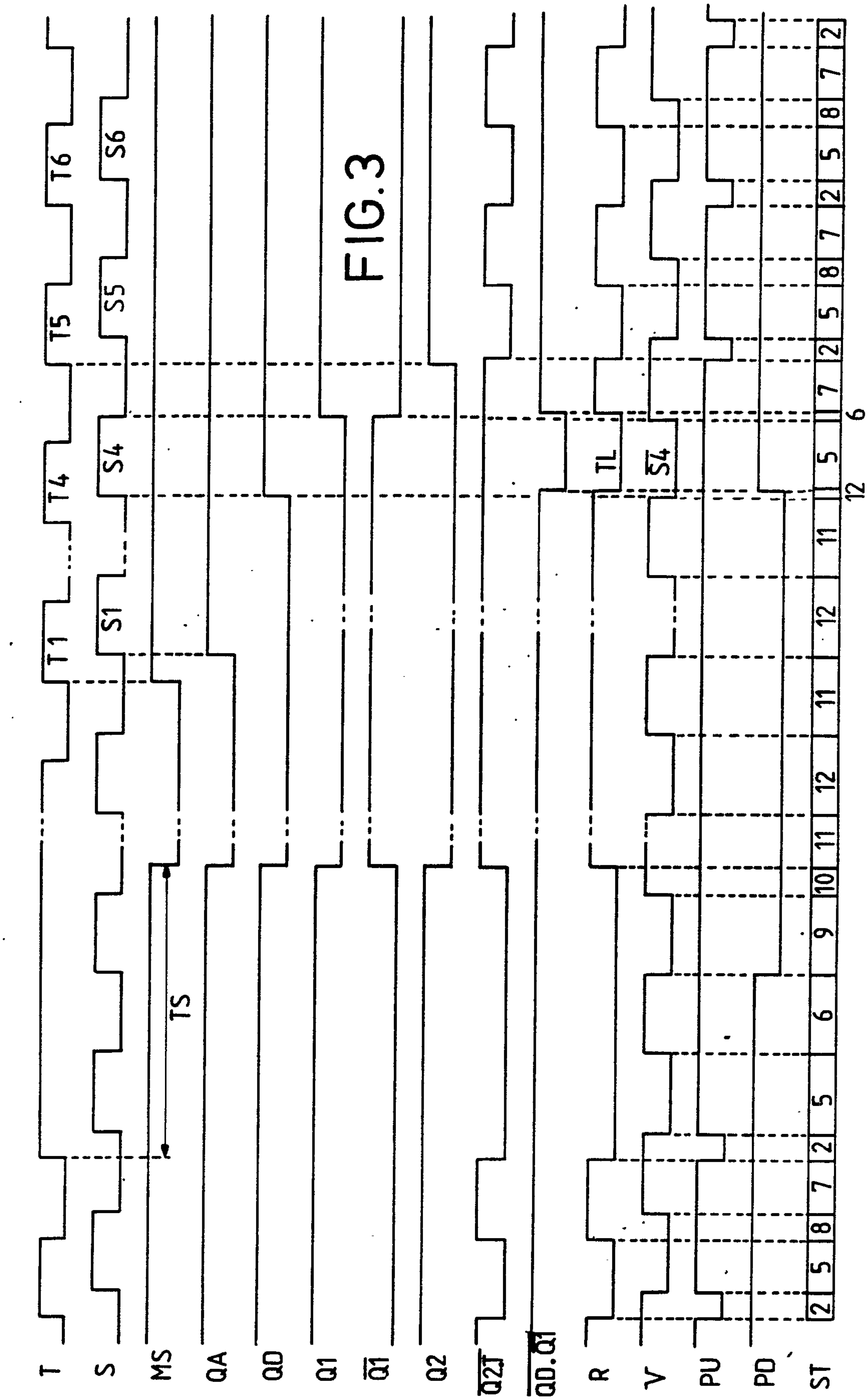
T
S
MS
QA
QD
Q1
Q1
Q2
Q2T
QD.Q1
R
V
PU
PD
ST
T1
T4
T5
T6
S1
S4
S5
S6
TS
TL
S4

FIG.3

FIG. 4

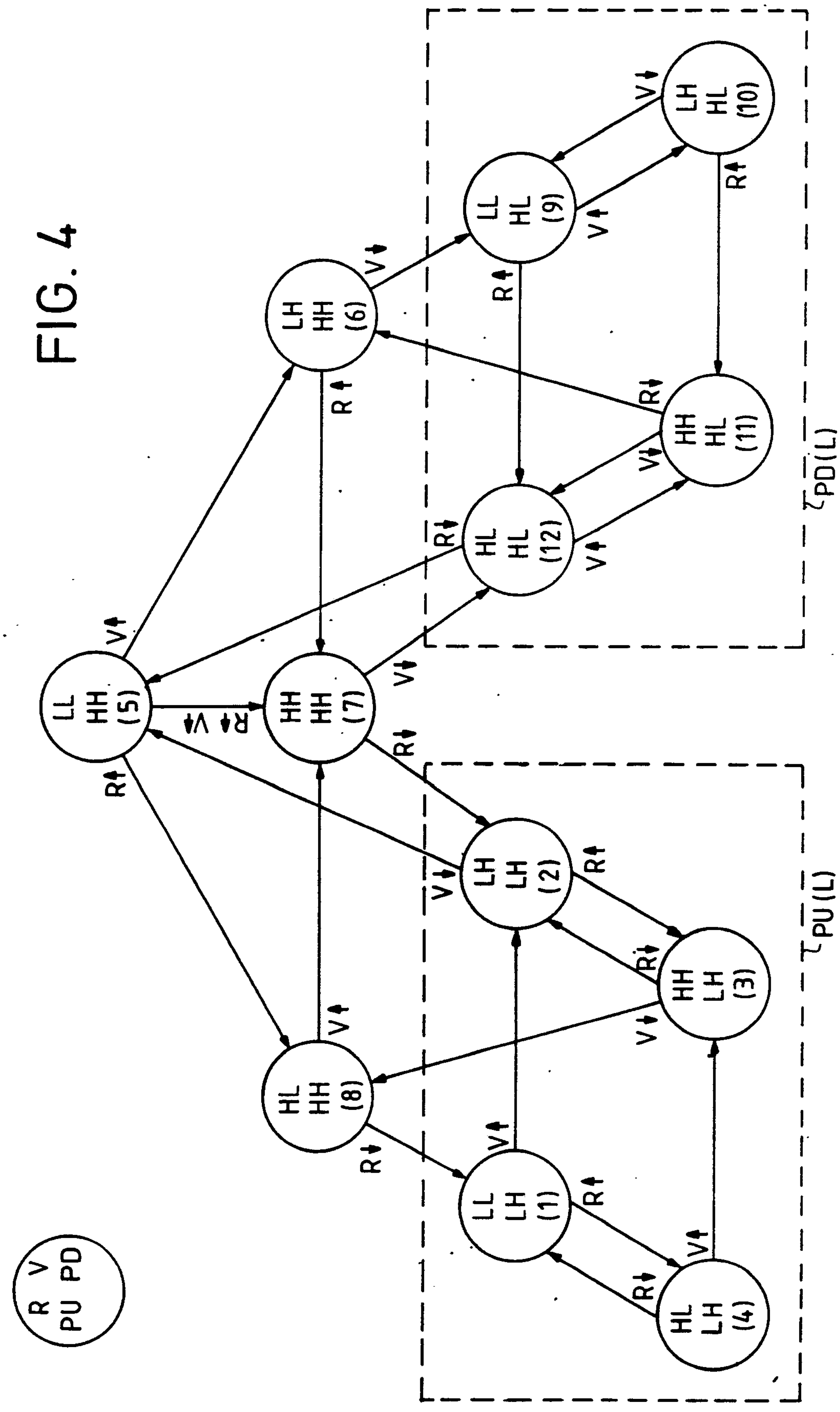
R V
PU PD
LL LH (1)
LH LH (2)
HH LH (3)
HL LH (4)
LL HH (5)
LH HH (6)
HH HH (7)
HL HH (8)
LL HL (9)
LH HL (10)
HH HL (11)
HL HL (12)
τPU(L)
τPD(L)